# EUROPEAN PATENT APPLICATION

(11) **EP 1 221 727 A2**
(43) Date of publication of application: **10.07.2002**
(21) Application number: 01310915.2
(22) Date of filing: 27.12.2001
(51) Int. Cl.: H01L 41/18

(54) **Electrostrictive material and manufacturing method**

(30) Priority: 27.12.2000 JP 2000398328
(71) Applicant: National Institute of Advanced Industrial Science and Technology, Tokyo (JP)
(72) Inventor: Xu, Chao-Nan, c/o National Institute of Advanced, Shuku, Tosu, Saga (JP); Liu, Yun, Kaleen, ACT 2617 (AU); Tateyama, Hiroshi, c/o National Institute of, 807-1, Shuku, Tosu, Saga (JP)
(74) Representative: Findlay, Alice Rosemary

(57) **Abstract**

An electrostrictive material comprises a compound formed of two or more elements by selecting one or more elements from the group consisting of Sr, Ba, Mg, Ca, Zn and Cd, and the group consisting or Al, Ga and Si, respectively, and oxygen. The compound may be represented by MₓAl_{y}O_{(2x +} _{3y)/2} where M represents one or more elements selected from the group consisting of Sr, Mg, Ca, Ba, Zn and Cd; and x and y are values each within a range from 1 to 20. One or more rare earth or transition metal elements may be added in an amount within a range from 0.001 to 20 mol.%. The electrostrictive material has a large strain relative to an input electric field, is a non-lead material, and is low in temperature dependency and hysteresis.

## Description

The present invention relates to a novel electrostrictive material and a manufacturing method therefor. More particularly, the invention relates to an electrostrictive material suitable for use in an electrostrictive actuator using the electrostriction effect, and a manufacturing method therefor.

Lead magnesium-niobate (Pb (Mg_{1/3}Nb_{2/3}) O₃ is conventionally known as an electrostrictive material, which is a perovskite compound generally expressed as ABO₃ where A forms a primitive lattice, B being located at the body-centered position thereof, and O being located at the face-centered position thereof.

Pb (Mg_{1/3}Nb_{2/3})ₗ₋ₓTiₓO₃-based materials in which the site B of lead magnesium-niobate, i.e., a part of the body-centered position of the primitive lattice of a perovskite compound is replaced by titanium are also applied as electrostrictive materials. For example, Pb (Mg_{1/3}Nb_{2/3})_{0.9}Ti_{0.1}O₃ has an electrostriction effect of 1.2 x 10⁻³ in an electric field of 1.0 kV/mm, and is used in an electrostrictive actuator as a material giving a large strain relative to the input electric field and a small hysteresis.

There is an increasing demand for development of a precision displacive element in the area of precision control and optical devices, and research activities have been made into a displacive driving element using the electrostriction effect. Electrostrictive materials used in this area of industry are required to be capable of being driven under a low voltage, give a large electrostrictive strain, and low in temperature dependency and hysteresis to achieve a high linearity. However, conventional electrostrictive materials do not have the necessary properties to satisfy the requirements for higher performance. More specifically, conventional electrostrictive materials have an amount of strain of only up to 2 x 10⁻³. When using these materials for an electrostrictive actuator, therefore, the problem arises that the amount of displacement is small and so the driving voltage has to become larger.

Furthermore, from the point of view of environmental preservation, development of a new non-lead based material to take the place of the conventional lead-based electrostrictive materials is attracting general attention as a very important issue.

The present invention has an object of providing a novel electrostrictive material which has a large strain relative to an input electric field, is a non-lead based material, and is low in temperature dependency and hysteresis, as well as a manufacturing method therefor.

The electrostrictive material of the present invention mainly comprises a compound composed of two or more elements obtained by selecting one or more elements from the group consisting of Sr, Ba, Mg, Ca, Zn and Cd and the group consisting of Al, Ga and Si, respectively, and oxygen, or a compound represented by MₓAl_{y}O₍₂ₓ₊ _{3y)/2} (where, M represents one or more elements selected from the group consisting of Sr, Mg, Ca, Ba, Zn and Cd; and x and y take values each within a range of from 1 to 20), or any of these compounds, to which one or more rare-earth or transition metal elements are added in an amount within a range of from 0.001 to 20 mol.%.

The above-mentioned electrostrictive material can be formed into an easily workable composite organic-inorganic electrostrictive material by dispersing the material into a polymer.

A method of manufacturing an electrostrictive material of the invention comprises the steps of mixing raw materials composed of two or more elements obtained by selecting one or more elements from the group consisting of Sr, Ba, Mg, Ca, Zn and Cd and the group consisting of Al, Ga and Si, respectively, and oxygen; or a compound represented by MₓAl_{y}O_{(2x+3y)/2} (where, M represents one or more elements selected from the group consisting of Sr, Mg, Ca, Ba, Zn and Cd; and x and y take values each within a range of from 1 to 20); or by adding one or more rare-earth or transition metal elements in an amount within a range from 0.001 to 20 mol.%; sintering the resultant mixture in an oxidizing atmosphere at a temperature within a range of from 200 to 1,500°C, and then sintering the same in a reducing atmosphere at a temperature within a range from 500 to 2,000°C.

A composite organic-inorganic electrostrictive material of sheet or any other desired shape can be produced by mixing powder of the electrostrictive material resulting from the above-mentioned method with a polymer, and heating the same.

The electrostrictive material has a maximum amount of strain far larger than that of conventional electrostrictive materials, and is thermally as well as chemically stable, is low in temperature dependency and hysteresis, and is a safe non-lead based material.

The invention will now be further described by way of example only with reference to the accompanying drawings in which

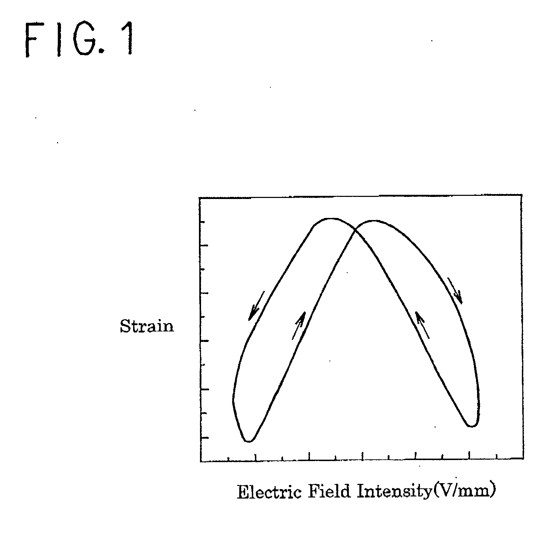

Fig. 1 is a graph illustrating the amount of strain relative to an input electric field of the electrostrictive material of the present invention.

Electric striction material is defined as material that gives electric striction by the application of electric field, the strain of which is proportional to the square of the electric field. The electric striction materials can be classified into piezo-type and electrostrictive type ones. The piezo type material requires polarizing operation, and the strain value has hysteresis during increasing and decreasing electrical field. On the other hand, unlike the piezo type, the electrostrictive type material does not need the polarizing treatment, but it generally possesses a large dielectric constant and large temperature dependency, so that the electrostrictive property is largely dependent upon temperature. An electrostrictive type materials commonly used at present are relaxers known to show a relative high electrostriction strain. A representative substance is Pb (Mg_{1/3}Nb_{2/3})O₃-PbTiO₃ (PMN-PT) solid solution. This solid solution exhibits a large electric-field induced strain at room temperature near the 0.91 PMN × 0.09 PT composition. This material has problems of a high temperature dependency because the amount of strain is seriously affected by the dielectricity, a large driving current resulting from the large specific inductive capacity, and environmental difficulties, being a lead-based material.

Generally ordinary dielectrics are known to show an electrostriction effect by the application of an electric field, but normally the dielectric materials show small electric striction (<10⁻⁶). A material with large electric-field induced strain has hitherto not been available. However, a novel material system quite different from conventional electrostrictive material systems has now been found by widely searching for a thermally and chemically stable material among the dielectrics.

This novel electrostrictive material comprises a compound composed of two or more elements obtained by selecting one or more elements from the group consisting of Sr, Ba, Mg, Ca, Zn and Cd and the group consisting of Al, Ga and Si, respectively, and oxygen; or a compound represented by MₓAl_{y}O_{(2x+3y)/2}; or by adding one or more selected from rare-earth metal elements such as Eu, Ce, Sm, Tb, Dy and Nd, or from transition metal elements such as Mn, Zn and Cu in an amount within a range from 0.001 to 20 mol.%.

Electrostriction effect can be remarkably improved by adding rare-earth or transition metal elements as described above. Addition of these elements in a amount of under 0.001 mol.% does not give an effect, and an amount of addition of over 20 mol.% does not permit maintenance of the crystal structure, thus reducing the effect of addition.

Applicable starting materials for manufacturing the above-mentioned electrostrictive material include various oxides such as SrCO₃, Al₂O₃, SiO₂, MgO, BaCO₃, MnCO₃, ZnCO₃, Ga₂O₃, and Eu₂O₃. The starting material is not however limited to those enumerated above, but any other compound is applicable so far as it finally forms an oxide.

The aforementioned electrostrictive material is manufactured by weighing and blending appropriately selected starting materials so as to achieve a desired chemical composition, sufficiently mixing and drying the same, then calcining the mixture in an oxidizing atmosphere at a temperature within a range from 200 to 1,500°C, forming the resultant calcined product into a desired shape by crushing and mixing the calcined product as required, and baking the formed product in a reducing atmosphere at a temperature within a range from 500 to 2,000°C.

In order to synthesize an easily workable electtrostrictive material, it is favorable to prepare the material into a composite organic-inorganic electrostrictive material by dispersing ceramic powder of the above-mentioned electrostrictive material in a polymer. The above-mentioned polymer may be a resin, a rubber, cellulose, PVDF or PTFE. The mixing ratio varies with the kind of polymer, and can be selected from a wide range of weight ratios from 1 to 99%.

In order to achieve a composite organic-inorganic electrostrictive material by dispersing the electrostrictive material resulting from the above-mentioned method in a polymer, it suffices to form the material into a sheet shape or any other desired shape by mixing a required amount of the electrostrictive material powder with a polymer, adding a solvent in response to the polymer, and heating the same to an appropriate temperature.

According to the present invention, as described above in detail, it is possible to obtain an electrostrictive material which has a large strain relative to an electric field and gives a maximum amount of strain far larger than the conventional one. Because this novel electrostrictive material is free from lead, and chemically and thermally stable, applicability is expected in a wide range of uses including an electrostrictive actuator and various control processes as a safe non-lead nature-friendly electrostrictive material.

### Examples

The present invention will now be described further in detail by means of examples.

### [Ceramic-system electrostrictive material]

Various oxides including SrCO₃, Al₂O₃, SiO₂, MgO, BaCO₃, MnCO₃, ZnCO₃, Ga₂O₃ and Eu₂O₃ were used as raw materials. The starting materials were weighed and sufficiently mixed so as to achieve a chemical composition shown in Table 1, dried at 120°C and then calcined at 900°C for about an hour. The resultant product was crushed and mixed again, and formed into a disc shape having a diameter of 20 mm and a thickness of about 2 mm, and the resultant formed product was baked at 1,300°C for four hours in a reducing atmosphere (100 ml/minute of Ar containing 5% H₂). Sample of 1-8 was baked at 1,100°C for four hours because of a low melting point. These baked samples were polished into a thickness of 1 mm, and then Au electrodes were prepared on the both sides, and the amount of strain was measured by means of a laser displacement meter by impressing a triangular wave of 0.1 Hz and 1 kV/mm. The result is shown in Fig. 1. The maximum amount of strain of the prepared electrostrictive material ceramics shown in Table 1 was determined from measured values shown in Fig. 1.

**[Table 1]**

| Sample No. | Material | Electrostrictive Property Max. Amount of Strain ( × 10⁻³) |
|---|---|---|
| Comparative Example | Pb (Mg_{1/3}Nb_{2/3})O₃ | 1.0 |
| 1-1 | Eu_{0.01}Sr_{0.99}Al₂O₄ | 12 |
| 1-2 | Eu_{0.001}Sr_{0.995}Al₂O₄ | 8.1 |
| 1-3 | Eu_{0.01}Ba_{0.59}Sr_{0.40}A₂O₄ | 3.4 |
| 1-4 | Eu_{0.01}Sr_{2.99}Al₂O₆ | 2.5 |
| 1-5 | Eu_{0.01}Sr_{0.99}MgAl₁₀O₁₇ | 2.9 |
| 1-6 | Eu_{0.01}Ba_{0.99}Al₂O₄ | 3.6 |
| 1-7 | Eu_{0.01}Ca_{0.99}Al₂O₄ | 2.4 |
| 1-8 | Eu_{0.01}Ba_{0.99}MgSi₂O₈ | 4.5 |
| 1-9 | Mn_{0.005}Zn_{1.995}Al₂O₄ | 1.1 |
| 1-10 | Mn_{0.005}Mg_{1.995}Ga₂O₄ | 1.2 |

As is known from Table 1, the maximum amount of strain of 10⁻² is ten times as high as that of the conventional ceramic material. This reveals that the electrostrictive material of the invention is an epoch-making one exhibiting a huge electrostriction effect.

### [Composite organic-inorganic electrostrictive material]

First, an electrostrictive material powder was prepared in the following procedure. Various oxides including SrCO₃, Al₂O₃, SiO₂, MgO, BaCO₃ and Eu₂O₃ were used as starting materials. The starting materials were weighed so as to achieve the chemical composition shown in Table 2, sufficiently mixed, then dried at 120°C, calcined at 600°C for about an hour, and then baked at 1,300°C for four hours in a reducing atmosphere (100 ml/minute of Ar containing 5% H₂). Sample of 1-8, which had a low melting point, was baked at 1,100°C for four hours. The resultant products were crushed and classified to obtain an electrostrictive material powder.

Then, the above-mentioned electrostrictive material powder was mixed with a polymer mixture (80% PVDF + 20% PTEF) at a weight ratio of 5:5, and then formed into a disc shape having a diameter of 20 mm and a thickness of about 2 mm at 120°C. The resultant formed products were polished in the same manner as in the aforementioned ceramic electrostrictive material into a thickness of 1 mm, and Au electrodes were prepared on the both sides. Then, a triangular wave of 0.1 Hz and 1 kV/mm was applied, and the amount of strain was measured by means of a laser displacement meter. The maximum amounts of strain shown in Table 2 were determined from values measured in the same manner as in the use of the ceramic electrostrictive material.

As described above, advantages of very simple forming and easy working are available by preparing a composite organic-inorganic material from the ceramic-based electrostrictive material powder and the polymer.

**[Table 2]**

| Sample No. | Material | Electrostrictive Property Max. Amount of Strain ( × 10⁻³) |
|---|---|---|
| Comparative | Pb (Mg_{1/3}Nb_{2/3})O₃ | 1.0 |
| Example | | |
| 2-1 | Eu_{0.01}Sr_{0.99}Al₂O₄ | 13 |
| | +Polymer | |
| 2-2 | Eu_{0.001}Sr_{0.995}Al₂O₄ | 8.6 |
| | +Polymer | |
| 2-3 | Eu_{0.01}Ba_{0.59}Sr_{0.40}A₂O₄ | 3.3 |
| | +Polymer | |
| 2-4 | Eu_{0.01}Sr_{2.99}Al₂O₆ | 5.9 |
| | +Polymer | |
| 2-5 | Eu_{0.01}Sr_{0.99}MgAl₁₀O₁₇ | 2.1 |
| | +Polymer | |
| 2-6 | Bu_{0.01}Ba_{0.99}Al₂O₄ | 3.2 |
| | +Polymer | |
| 2-7 | Eu_{0.01}Ca_{0.99}Al₂O₄ | 2.0 |
| | +Polymer | |
| 2-8 | Eu_{0.01}Ba_{0.99}MgSi₂O₈ | 4,9 |
| | +Polymer | |
| 2-9 | Mn_{0.005}Zn_{1.995}Al₂O₄ | 2.1 |
| | +Polymer | |
| 2-10 | Mn_{0.005}Mg_{1.995}Ga₂O₄ | 2.9 |
| | +Polymer | |

## Claims

1. An electrostrictive material comprising a compound formed of two or more elements by selecting one or more elements from the group consisting of Sr, Ba, Mg, Ca, Zn and Cd and the group consisting of Al, Ga and Si, respectively, and oxygen.

2. An electrostrictive material of claim 1, to which one or more rare earth or transition metal elements is added in an amount within a range from 0.001 to 20 mol.%.

3. An electrostrictive material of claim 1 or claim 2 wherein the compound is represented by MₓAl_{y}O_{(2x + 3y)/2} where M represents one or more elements selected from the group consisting of Sr, Mg, Ca, Ba, Zn and Cd and x and y are values each within a range of from 1 to 20.

4. An electrostrictive material according to any preceding claim wherein said electrostrictive material is formed into an organic-inorganic type composite by dispersing the material into a polymer.

5. A method of manufacturing an electrostrictive material comprising the steps of mixing raw materials for synthesizing an electrostrictive material comprising a compound formed of two or more elements obtained by selecting one or more elements from the group consisting of Sr, Ba, Mg, Ca, Zn and Cd and the group consisting of Al, Ga and Si, respectively, and oxygen, baking the resultant mixture in an oxidizing atmosphere at a temperature within a range from 200 to 1500°C, and then baking the same in a reducing atmosphere at a temperature within a range from 500 to 2000°C.

6. A method of claim 5 further comprising adding one or more rare earth or transition metal elements in an amount within a range from 0.001 to 20 mol.% to the mixture.

7. A method of either claim 5 or claim 6 wherein the compound is represented by MₓAl_{y}O_{(2x+3y)/2} where M represents one or more elements selected from the group consisting of Sr, Mg, Ca, Ba, Zn and Cd and x and y are values each within a range from 1 to 20.

8. A method of manufacturing a composite organic-inorganic electrostrictive material, comprising the steps of mixing powder of an electrostrictive material manufactured by the method of any one of claims 5 to 7 with a polymer, and forming the resultant mixture into a desired shape by heating.
